# EUROPÄISCHE PATENTANMELDUNG

(11) **EP 1 603 068 A2**
(43) Veröffentlichungstag der Anmeldung: **07.12.2005**
(21) Anmeldenummer: 04090500.2
(22) Anmeldetag: 22.12.2004
(51) Int. Cl.: G06F 19/00, G01N 23/20, C30B 7/00, G01J 3/44, G01N 21/31, C30B 29/58, C12N 15/00

(54) **Verfahren zur Überwachung der Herstellung von Biomolekülkristallen**

(30) Priorität: 05.02.2004 DE 102004005878
(71) Anmelder: RiNA Netzwerk RNA-Technologien GmbH, 14195 Berlin (DE); Rapp OptoElectronic GmbH, 22880 Wedel (DE); PLS Design GmbH, 20255 Hamburg (DE); Universitätsklinikum Hamburg-Eppendorf, 20246 Hamburg (DE)
(72) Erfinder: Betzel, Christian, D-22607 Hamburg (DE); Dierks, Karsten, 22769 Hamburg (DE); Rapp, Gert, 22559 Hamburg (DE)
(74) Vertreter: Jungblut, Bernhard Jakob

(57) **Zusammenfassung**

Die Erfindung betrifft ein Verfahren zur Überwachung der Herstellung von Makromolekülkristallen, welche zumindest einen Fluoreszenzemitter enthalten, mit den folgenden Verfahrensstufen: a) eine Lösungsvolumen enthaltend gelöste Makromoleküle einer Molekülspezies mit zumindest einem Fluoreszenzemitter wird Bedingungen unterworfen, welche die Makromoleküle zu Makromolekülkristallen kristallisieren lassen oder von welchen erwartet wird, dass sie die Makromoleküle zu Makromolekülkristallen kristallisieren, b) das Lösungsvolumen aus Stufe a wird mit kohärentem Licht bestrahlt und das von Makromolekülkristallen gestreute Licht wird in zumindest einem definierten Raumwinkelbereich mit Mitteln zur Detektion von Streulicht detektiert, c) vor, gleichzeitig mit, oder nach Stufe b wird das Lösungsvolumen mit einer Lichtquelle bestrahlt, deren Lichtemission zur Anregung des Fluoreszenzemitters geeignet ist und Fluoreszenzlicht wird mit Mitteln zur Detektion von Fluoreszenzlicht detektiert, sowie eine Vorrichtung zur Durchführung des Verfahrens.

## Beschreibung

### Gebiet der Erfindung

Die Erfindung betrifft ein Verfahren zur Überwachung der Herstellung von Biomolekülkristallen, welche zumindest einen Fluoreszenzemitter enthalten, mit den folgenden Verfahrensstufen: ein Lösungsvolumen enthaltend gelöste Biomoleküle mit zumindest einem Fluoreszenzemitter wird Bedingungen unterworfen, welche die Biomoleküle zu Biomolekülkristallen kristallisieren lassen oder von welchen erwartet wird, dass sie die Biomoleküle zu Biomolekülkristallen kristallisieren lassen; das Lösungsvolumen wird mit einer Lichtquelle bestrahlt, deren Lichtemission zur Anregung des Fluoreszenzemitters geeignet ist und Fluoreszenzlicht wird mit Mitteln zur Detektion von Fluoreszenzlicht detektiert; und die von den Mitteln zur Detektion von Fluoreszenzlicht erzeugten Signale werden einer Auswerteeinheit zugeführt, in welcher die Signale in eine Fluoreszenzintensität transformiert werden, wobei die Fluoreszenzintensität mit einer Sollfluoreszenzintensität verglichen wird.

### Hintergrund der Erfindung und Stand der Technik

Aus der Literaturstelle EP 1 022 549 A1 ist ein Verfahren bekannt, in welchem eine Mikro- oder Nanopartikel enthaltende Flüssigkeit mit zeitlich und räumlich kohärentem Licht, beispielsweise erzeugt mittels eines Lasers, bei einer Mehrzahl diskreter Wellenlängen bestrahlt wird, wobei (rück-) gestreute Strahlung detektiert wird und wobei Intensitätsfluktuationen der gestreuten Strahlung bei jeder der eingestrahlten Wellenlängen bestimmt werden. Hierbei handelt es sich um eine Variante der Dynamic Light Scattering (DLS) bzw. Photon Correlation Spectroscopy (PCS) Methode, wobei durch den Einsatz verschiedener Wellenlängen Messungen mit unterschiedlichen Streuwinkeln zum Zwecke der Kompensation für u.a. Mehrfachstreueffekte entbehrlich werden. Mit dieser Methode kann letztlich durch Messung der zeitlichen Abhängigkeiten der Fluktuationen und Autokorrelation der resultierenden Funktion eine Bestimmung der Partikelgrößenverteilung bzw. von Partikelgrößen erfolgen. In dieser Literaturstelle sind weiterhin Vorrichtungen zur Durchführung des Verfahrens ausführlich beschrieben. Diese weisen im Kern eine definierte Anzahl (2 oder mehr) an Lasern mit unterschiedlichen Emissionswellenlängen (im sichtbaren Licht bis zum nahen IR) auf, deren Licht über beispielsweise optische Leiter zur Probe geleitet wird. Rückgestreutes Licht wird gleichzeitig mittels optischer Leiter aufgefangen, detektiert und ausgewertet.

Aus der Literaturstelle WO 02/081502 A2 ist ein Verfahren zur Optimierung von Kristallisierungsversuchen im Rahmen von high throughput Kristallisationsversuchen bekannt, wobei eine Lösung einer gelbildenden Komponente enthaltend Biomoleküle einer Biomolekülspezies mit einer weiteren für die Kristallisation förderlichen Substanz mittels einer automatischen Vorrichtung zur Abgabe der Substanz versetzt wird. Dadurch können eine Vielzahl von Lösungen, welche beispielsweise als eine Vielzahl von Tropfen auf einer Platte angeordnet sind, mit hohem Durchsatz Kristallisationsversuchen unterworfen werden.

Im Rahmen von Kristallisationsversuchen an Biomolekülen, beispielsweise um Kristalle zu Zwecken der Röntgenstrukturanalyse zu erzeugen, ist es erforderlich, den Kristallisationsvorgang zu prüfen, wobei zudem Biomolekülkristalle von sich ggf. auch bildenden Salzkristallen unterschieden werden müssen. Dies erfolgt in der Praxis beispielsweise durch Beobachtung der eine Biomolekülspezies enthaltenden Lösung mittels einfacher optischer Methoden, beispielsweise unter Verwendung eines Mikroskopes. In Anbetracht der regelmäßig bestehenden Schwierigkeit Biomoleküle zu kristallisieren bzw. geeignete Kristallisierungbedingungen zu schaffen, sind oft eine Vielzahl von Kristallisierungversuche erforderlich. Die bisherigen Kristallisierungmethoden, auch die vorstehenden high throughput Methoden, weisen als einen wesentlichen zeitkritischen Schritt die Detektion erfolgreicher Kristallisation auf, da die Beobachtung durch eine Bedienperson aufwändig ist und zudem eine relativ hohe Fehlerträchtigkeit mit sich bringt.

Technisches Problem der Erfindung.

Der Erfindung liegt daher das technische Problem zu Grunde, ein Verfahren und eine Vorrichtung anzugeben, mittels welcher einfach, schnell, zuverlässig und insbesondere automatisiert die Bildung von Biomolekülkristallen festgestellt werden kann.

Grundzüge der Erfindung und Ausführungsformen derselben.

Zur Lösung dieses technischen Problems lehrt die Erfindung ein Verfahren zur Überwachung der Herstellung von Makromolekülkristallen, mit den folgenden Verfahrensstufen: a) ein Lösungsvolumen enthaltend gelöste Makromoleküle mit zumindest einem Fluoreszenzemitter wird Bedingungen unterworfen, welche die Makromoleküle zu Makromolekülkristallen kristallisieren lassen oder von welchen erwartet wird, dass sie die Makromoleküle zu Makromolekülkristallen kristallisieren lassen, b) das Lösungsvolumen aus Stufe a wird mit kohärentem Licht bestrahlt und das von Makromolekülkristallen gestreute Licht wird in zumindest einem definierten Raumwinkelbereich mit Mitteln zur Detektion von Streulicht detektiert, c) vor, gleichzeitig mit, oder nach Stufe b wird das Lösungsvolumen mit einer Lichtquelle bestrahlt, deren Lichtemission zur Anregung des Fluoreszenzemitters geeignet ist und Fluoreszenzlicht wird mit Mitteln zur Detektion von Fluoreszenzlicht detektiert.

Die Detektion von Floureszenzlicht kann insbesondere als zweidimensionales Floureszenzlichtbild des Lösungsvolumens erfolgen.

Das erfindungsgemäße Verfahren ist insbesondere für Biomoleküle geeignet. Daher beziehen sich die folgenden Ausführungen auf Biomolekülkristalle, sind jedoch entsprechend auf beliebige Makromoleküle anwendbar.

Die Erfindung kombiniert im Kern zwei verschiedene per se bekannte Verfahren zum Zwecke der automatisierbaren Überwachung der Entstehung von Biomolekülkristallen. Die Messung (rück-) gestreuten kohärenten Lichtes dient letztendlich der Detektion, ob überhaupt Kristalle entstehen und bejahendenfalls der Größe dieser Kristalle, und die Messung des Fluoreszenzlichtes bzw. die Aufnahme des Floureszenzlichtbildes dient der Unterscheidung von Biomolekülkristallen von beispielsweise Salzkristallen, die einen Fluoreszenzemitter typischerweise nicht enthalten. Durch diese Kombination wird die Bildung von Biomolekülkristallen mit sehr hoher Sicherheit, auch eventuelle Salzkristallbildung diskriminierend, detektiert. Wird in Stufe b) eine Partikelbildung detektiert und zeigt ein Fluoreszenzlichtbild keinerlei Punktbereiche mit hoher Fluoreszenzintensität, so handelt es sich bei den Partikeln um Salzkristalle. Werden dagegen in Stufe b) zugleich Punktbereiche mit hoher Fluoreszenzintensität gemessen, so handelt es sich bei den Punktbereichen um Makromolekülkristalle.

Eine Automatisierung des erfindungsgemäßen Verfahrens ist unschwer möglich, indem die folgenden Verfahrensschritte angeschlossen werden: d) die von den Mitteln zur Detektion von Streulicht erzeugten Signale werden einer Auswerteeinheit zugeführt, in welcher die Signale in eine Partikelgröße oder eine hiermit korrelierte Messgröße transformiert werden, wobei die Partikelgröße bzw. die Messgröße mit einer definierten Sollpartikelgröße bzw. Sollmessgröße verglichen wird, e) die von den Mitteln zur Detektion von Fluoreszenzlicht erzeugten Signale werden einer Auswerteeinheit zugeführt, in welcher die Signale in eine Fluoreszenzintensität transformiert werden, wobei die Fluoreszenzintensität (in einer Bildebene aufgelöst, bzw. der Punktbereiche maximaler Fluoreszenzintensität in einem Fluoreszenzlichtbild) mit einer Sollfluoreszenzintensität verglichen wird, f) Biokristalle werden selektiert, wenn die Partikelgröße oberhalb der Sollpartikelgröße bzw. die Messgröße oberhalb der Sollmessgröße und zugleich die Fluoreszenzintensität oberhalb der Sollfluoreszenzintensität liegt.

Durch den Vergleich der Partikelgröße mit der Sollpartikelgröße bzw. der Messgröße mit der Sollmessgröße sowie der Floureszenzintensität mit der Sollfloureszenzintensität erfolgt eine automatische Detektion, wenn i) sich Kristalle bilden und ii) es sich bei den gebildeten Kristallen um Biokristalle handelt. Dabei kann die Sollpartikelgröße sehr gering angesetzt werden, wobei dann die Kristallbildung per se detektiert wird, der Wert kann aber mit der Maßgabe gewählt sein, dass die Kristallgröße hinreichend für beispielsweise Röntgenstrukturanalysen ist. Im Falle der Sollfluoreszenzintensität liegt deren Wert zumindest um den Faktor 2 der von der gleichen Lösung, jedoch mit vollständig in Lösung befindlichen Biomolekülen, unter ansonsten identischen Bedingungen emittierten Fluoreszenzstrahlung (ein Kristall weist eine höhere Fluoreszenzintensität auf als die Lösung aufgrund der räumlichen Konzentration der Moleküle im Kristall). In jedem Fall wird bei der Erreichung beider Kriterien ein Signal erzeugt, welches den positiven Biokristallisierungsversuch signalisiert. Solche Signale können dann auch zur Ansteuerung weiterer Prozesse und/oder automatischer Handhabungsvorrichtungen eingesetzt werden.

Grundsätzlich ist das erfindungsgemäße Verfahren bereits einsetzbar, auch in der automatisierten Version, bei der Überwachung eines einzigen Kristallisierungsversuches. Besonders effektiv und folglich mit schnellen Ergebnissen im Sinne der erfolgreichen Herstellung eines Biokristalles ist es, wenn eine Mehrzahl von Lösungsvolumina enthaltend gleiche oder verschiedene Biomoleküle gleichzeitig oder subsequent den Stufen a bis f unterworfen werden, wobei die Kristallisationsbedingungen der Stufe a in den verschiedenen Lösungsvolumina gleich oder verschieden sein können, und wobei die Mehrzahl von Lösungsvolumina vorzugsweise auf oder in einem Trägerelement angeordnet sind.

Geeignete Trägerelemente sind beispielsweise sogenannte multi well plates, welche eine Mehrzahl, beispielsweise 96, Vertiefungen aufweisen, in welche Lösungen eingebracht werden können. Solche Platten sind standardisiert und es stehen eine Vielzahl von automatisierten Vorrichtungen zum automatischen Befüllen und zur automatischen Manipulation solcher Platten zur Verfügung. In einer anderen Variante weist das Trägerelement keine Vertiefungen auf, sondern deren plane Oberfläche ist bis auf abgeschlossene Probenbereiche hydrophobiert. Solche Platten sind bekannt, ebenso geeignete Hydrophobierungsbeschichtungen. Bei diesen Platten wird eine Lösung in einem Probenbereich als Tropfen aufgebracht, wobei aufgrund der umgebenden hydrophoben Oberfläche eine Ausbreitung des Tropfens und folglich die Gefahr einer Vermischung mit benachbarten Tropfen vermieden ist.

Die Anzahl an Lösungsvolumina bzw. der Vertiefungen oder Probenbereiche kann grundsätzlich im Bereich von 5 bis 1000, vorzugsweise 50 bis 500, liegen.

Grundsätzlich ist die Abfolge der Stufen b und c beliebig, beispielsweise auch gleichzeitig. Ein hoher Durchsatz bei gleichzeitig hoher Miniaturisierung einer erfindungsgemäßen Vorrichtung ist dann erreichbar, wenn die Stufen b und c nacheinander, b nach c oder c nach b, durchgeführt werden. Denn dann lassen sich beispielsweise auf ein lösungsvolumen gerichtete Lichtleiter für beide Stufen einsetzen und separate Lichtleiter für die Stufen sind dann entbehrlich.

Die Stufe b) kann in verschiedenen Varianten ausgeführt werden. Im Falle von nur wenigen sich bildenden Kristallen kann es ausreichen, kohärentes Licht nur einer Wellenlänge einzusetzen und die Detektion des Streulichtes bei nur einem (Rück-) Streuwinkel durchzuführen. Denn bei Vorliegen nur sehr weniger Kristalle sind einerseits die Wahrscheinlichkeiten von Mehrfachstreuungen reduziert und andererseits finden aufgrund der geringen Anzahl an Kristallen pro Volumeneinheit weniger Verfälschungen durch verringerte mittlere freie Weglängen der sich mit Braun' schen Bewegungen bewegenden Kristalle statt. Jegliche Verfälschungen von Ergebnissen, insbesondere bei hoher Anzahl an Kristallen pro Volumeneinheit, lassen sich vermeiden, wenn kohärentes Licht bei verschiedenen diskreten Wellenlängen eingestrahlt wird und die Intensitätsfluktuationen des (rück-) gestreuten Lichtes wellenlängenselektiv gemessen werden. Hierbei können die Messungen bei verschiedenen Wellenlängen gleichzeitig oder nacheinander durchgeführt werden. Bei gleichzeitiger Durchführung kann grundsätzlich, ebenso wie bei subsequenter Durchführung, Einstrahlung des Primärlichtes und Aufnahme des gestreuten Lichtes mittels eines einzigen Lichtleiters erfolgen. Dies erfordert detektorseitig geeignete Auflösung nach Wellenlängen. Es ist aber auch möglich, mit je einem Primärlichtleiter für jede Wellenlänge und/oder je einem Streulicht-Lichtleiter für jede Wellenlänge zu arbeiten, wodurch der detektorseitige Aufwand reduziert wird auf Filterung der gewünschten Wellenlänge. Grundsätzlich ist es auch möglich beispielsweise mittels Fouriertransformationsalgorithmen die Auswertung von Intensitätsfluktuationen bei verschiedenen Wellenlängen durchzuführen, wodurch u.U. apparativ aufwändige Filter oder Spektroskope vermieden werden können.

Alternativ kann selbstverständlich zur Kompensation von Verfälschungen durch Mehrfachstreuung und hohen Partikeldichten mit der Detektion des Streulichtes in verschiedenen definierten Rückstreuwinkeln bei Bestrahlung mit einer einzigen Wellenlänge gearbeitet werden, was u.U. bevorzugt ist.

Für die Erzeugung des kohärenten Lichtes der Stufe b) lassen sich vorteilhafterweise Laser einsetzen. Die Emissionwellenlängen können dabei im Sichtbaren und im IR, beispielsweise dem nahen IR liegen. Die in Stufe c verwendete Lichtquelle kann beispielsweise eine für Floureszenzanregung übliche UV Lichtquelle sein, aber auch Lichtquellen im sichtbaren Bereich sind grundsätzlich nicht ausgeschlossen. Die Wellenlänge des zu detektierende Fluoreszenzlichtes kann im UV-Bereich, aber auch im sichtbaren Bereich liegen.

Die in Stufe c verwendete Lichtquelle kann polarisiertes Licht emittieren. In diesem Falle ist auch das Fluoreszenzlicht seinerseits polarisiert. Dann kann im Rahmen der Detektion des Fluoreszenzlichtes ein Polarisationsfilter vorgesehen sein, welcher eine Diskriminierung sowohl von Fremdlicht als auch von Streulicht erlaubt.

Grunsätzlich kann das kohärente Licht der Stufe b) und/oder das Licht der Lichtquelle aus Stufe c) mit beliebigen üblichen optischen Mitteln auf das Lösungsvolumen gerichtet und ggf. hierin fokusiert sein. Entsprechendes gilt für das Auffangen des Streulichtes und/oder des Fluoreszenzlichtes. Fremdlichteinflüsse lassen sich jedoch besonders effektiv vermeiden, wenn die Quellen für kohärentes Licht und/oder für Fluoreszenzanregung und/oder die Mittel zur Detektion von Streulicht und/oder die Mittel zur Detektion von Fluoreszenzlicht einen mit einem Ende hieran angeschlossenen Lichtleiter aufweisen, dessen entgegengesetztes Ende auf das Lösungsvolumen gerichtet ist. Die auf das Lösungsvolumen gerichteten Enden können dabei sehr nahe an dem Lösungsvolumen positioniert werden. Zudem lassen sich die Enden gleichsam bündeln, so dass ein sehr kompakter Messkopf entsteht, welcher auch den Einsatz bei sehr kleinen und dicht beieinander angeordneten Lösungsvolumina, wie bei high throughput Experimenten erforderlich, erlaubt.

Im Falle der Mittel zur Detektion des Fluoreszenzlichtes wird es sich empfehlen, wenn geeignete optische Elemente vorgesehen sind, durch welche das Lösungsvolumen oder zumindest ein Teilbereich hiervon als Fluoreszenzlichtbild auf einen zweidimensional ortsaufgelöst arbeitenden Detektor, beispielsweise einen im Bereich der Fluoreszenzlicht-Wellenlänge sensitiven CCD, abgebildet wird.

Die Mittel zur Detektion des Streulichtes und/oder des Fluoreszenzlichtes können grundsätzlich beliebig sein. In Frage kommen beispielsweise Halbleiterdetektoren, welche z.B. inhärent wellenlängenselektiv arbeiten können. Hohe Empfindlichkeiten werden jedoch erhalten wenn die besagten Mittel einen klassischen Photomultiplier aufweisen. Im Rahmen der Stufe c) kann zwischen dem Lösungsvolumen und den Mitteln zur Detektion von Floureszenzlicht ein UV-Filter zwischengeschaltet sein, beispielsweise zwischen einem Lichtleiter und den daran angeschlossenen Mitteln zur Detektion von Fluoreszenzlicht oder vor dem Objektiv einer Kamera.

Die Erfindung lehrt des Weiteren eine Vorrichtung zur Überwachung, vorzugsweise der Hochdurchsatzüberwachung, der Herstellung von Biokristallen, mit einem auf einem Basiselement angeordneten Trägerelement, auf oder in welchem ein Lösungsvolumen enthaltend gelöste Biomoleküle anbringbar ist, mit einer auf das Lösungsvolumen richtbaren Lichtquelle für kohärentes Licht, mit einer auf das Lösungsvolumen richtbaren Lichtquelle für Licht, welches zur Anregung eines Fluoreszenzemitters geeignet ist, mit Mitteln zur Detektion von Streulicht aus dem Lösungsvolumen, mit Mitteln zur Detektion von Fluoreszenzlicht aus dem Lösungsvolumen, und mit einer an die Mittel zur Detektion von Streulicht und die Mittel zur Detektion von Fluoreszenzlicht angeschlossenen Auswerteeinrichtung. Grundsätzlich gelten die vorstehend zu dem erfindungsgemäßen Verfahren getroffenen Ausführungen entsprechend auch für die erfindungsgemäße Vorrichtung.

Zum Zwecke der Durchführung von Kristallisationsexperimenten mit high throughput ist es zweckmäßig, wenn das Trägerelement eine Mehrzahl von Probenbereichen zur Aufnahme jeweils eines Lösungsvolumens aufweist. Die Lichtquelle zur Erzeugung von kohärentem Licht und/oder die Lichtquelle zur Erzeugung von zur Anregung des Fluoreszenzemitters geeigneten Lichtes und/oder die Mittel zur Detektion von Streulicht und/oder die Mittel zur Detektion von Fluoreszenzlicht können entweder einen gemeinsamen oder jeweils einen zugeordnete Lichtleiter umfassen, dessen freies Ende auf das Lösungsvolumen gerichtet ist. Es ist auch möglich, dass beispielsweise ein Lichtleiter einer Teilmenge der Lichtquellen und ein Lichtleiter den Mitteln zur Detektion zugeordnet ist. Beliebige Kombinationen einer Mehrfachnutzung von Lichtleitern sind einrichtbar.

Das freie Ende des Lichtleiters kann zur Aufnahme von Licht ausgerichtet sein, welches in einem Winkel von 0° bis 170°, beispielsweise 0° bis 80°, zur Achse des eingestrahlten Lichtes aus dem Lösungsvolumen emittiert wird.

Zum Zwecke der vollautomatischen Überwachung kann das Trägerelement oder können die Lichtquellen, die Mittel zur Detektion von Streulicht und die Mittel zur Detektion von Fluoreszenzlicht gegenüber dem Basiselement mittels einer Manipulatorvorrichtung verschiebbar sein. Dies wird sich insbesondere im Falle von Trägerelementen empfehlen, welche eine Mehrzahl von Lösungsvolumen tragen, da dann die Lösungsvolumen nacheinander dem erfindungsgemäßen Verfahren durch Einfahren eines Lösungsvolumens in eine Messposition, unterworfen werden können, und zwar automatisch gesteuert. Hierbei wird die Manipulatorsteuerung durch ein von der Auswerteeinheit generiertes Weiterschaltungssignal gesteuert, welches den Abschluß der Durchführung des erfindungsgemäßen Verfahrens an einem Lösungsvolumen signalisiert und in der Manipulatorsteuerung Steuersignale erzeugt, welche eine Relativbewegung von Lösungsvolumen und der anderen vorstehenden Komponenten mit der Maßgabe bewirkt, dass das untersuchte Lösungsvolumen aus der Messposition entfernt und durch ein noch zu untersuchendes anderes Lösungsvolumen ersetzt wird.

Von selbstständiger Bedeutung und völlig unabhängig von dem vorstehend beschriebenen Verfahren ist ein erfindungsgemäßes Verfahren zur Zentrierung eines Makromolekülkristalles aus Makromolekülen einer einen Fluoreszenzemitter enthaltenden Makromolekülspezies in einer Apparatur, beispielsweise einer Röntgenbeugungsapparatur, wobei ein Kristallhalter mit dem Makromolekülkristall mit Licht, welches zur Fluoreszenzanregung des Fluoreszenzemitters geeignet ist, bestrahlt wird, wobei ein Fluoreszenzlichtbild des Bereiches des Kristallhalters registriert wird, wobei Ortskoordinaten des registrierten Fluoreszenzlicht-Bildes mit Ortskoordinaten einer Kristallsollposition in der Apparatur korreliert sind, und wobei die Ortskoordinaten einer Fluoreszenzabbildung des Makromolekülkristalles im Fluoreszenzlichtbild mit den Ortskoordinaten der Kristallsollposition verglichen werden. Im Falle, dass bei dem vorstehenden Vergleich eine definierte Maximaldifferenz überschritten wird, kann manuell oder automatisch eine Korrektur der Position des Kristallhalters erfolgen. Letzteres erlaubt die Durchführung der Röntgenstrukturanalyse mit high throughput aufgrund der Automatisierung. Geeignete Nachführungstechnologien einschließlich der damit verbundenen Minipulatoren sind dem Fachmann wohl bekannt. Dieser Aspekt der Erfindung beruht darauf, dass ein fluoreszierender Makromolekülkristall aufgrund der Konzentration der Fluoreszenzemitter mit sehr hoher Intensität fluoresziert, verglichen mit der umgebenden Lösung und/oder dem Kristallhalter (beispielsweise eine Schlaufe aus einem organischen Polymerwerkstoff, wie Rayon). Mit bildgebenden Verfahren ist somit aufgrund des hohen Kontrastes eine sichere Identifiziereung des Makromolekülkristalles und dessen räumliche Anordnung in dem Kristallhalter möglich und wird zur exakten Positionierung in der Röntgenbeugungsapparatur genutzt.

### Definitionen.

Biomolekülkristalle sind Kristalle, deren kristallographische Wiederholungseinheiten durch Biomoleküle gebildet werden. Biomolekülkristalle erzeugen definierte Röntgenbeugungsmuster, aus welchen sich die räumliche Anordnung der Atome des Biomoleküles bestimmen läßt.

Biomoleküle sind typischerweise makromolekulare organische Verbindungen, welche in natürlichen Organismen vorkommen, oder welche selbst nicht in natürlichen Organismen vorkommen, jedoch mit natürlicherweise vorkommenden molekularen Bausteinen gebildet sind, oder welche aus molekularen Bausteinen gebildet sind, welche gegenüber natürlichen molekularen Bausteinen modifiziert sind. Für letztere kommen beispielsweise Bausteine in Frage, die durch Einbau eines Fluoreszenzemitters modifiziert sind. Beispiele für in Frage kommende Bausteine sind: natürliche Aminosäuren, nicht natürliche Isoformen natürlicher Aminosäuren, chemisch modifizierte Aminosäuren, natürliche Nukleotide, chemisch modifizierte Nukleotide, Zucker und Lipide. Beispiele für Biomoleküle sind Peptide, Proteine, Antikörper, Rezeptoren, Enzyme, Steroide, Oligonukleotide, Polynukleotide, Ribozyme, Aptamere, Komplexe mehrerer verschiedener oder gleicher Moleküle der vorstehenden Art, aber auch komplexe Strukturen, wie Zellkerne und Viren.

Makromoleküle haben ein MW von typischerweise mehr als 1.000, meist mehr als 10.000, bis zu 500.000 oder mehr. Makromoleküle umfassen einerseits die vorstehend genannten Biomoleküle. Anderseits fallen unter den Begriff der Makromoleküle auch organische Polymerverbindungen, welche nicht aus natürlichen molekularen Bausteinen oder modifizierten solchen Bausteinen aufgebaut sind. Solche Polymerverbindungen sind Polymerisationprodukte aus organischen Monomeren, gleich oder verschieden, beispielsweise Kunststoffe.

Der Begriff der Makromolekülspezies bzw. eine Biomolekülspezies bezeichnet eine definierte molekulare Struktur. Makromoleküle bzw. Biomoleküle einer Spezies weisen identische molekulare Strukturen auf, wobei der Begriff der Identität zumindest 80%, vorzugsweise zumindest 90%, in der Regel mehr als 95% bis zu 100%, Übereinstimmung, bezogen auf die chemische Summenformel oder die Sequenz, umfasst.

Ein Fluoreszenzemitter enthält beispielsweise eine aromatische molekulare Struktur, wie einen Benzolring oder einen entsprechenden Heteroring. In Proteinen kommen Benzolringe beispielsweise in Tryptophan, Tyrosin und Phenylalanin vor. Ein aromatischer Heteroring ist des Weiteren beispielsweise in Adenin vorhanden. Des Weiteren können fluoreszierende Moleküle, sich an Makromoleküle anlagern oder hiermit verbinden, wie beispielsweise Rhodamin oder Dextran blue, zugesetzt sein, wodurch die Makromoleküle bzw- Biomoleküle mit einem Fluoreszenzemitter versehen werden.

Ein Lösungsvolumen kann typischerweise im Bereich von 0,001 µl bis 10 ml, insbesondere von 0,01 µl bis 0,1 ml, liegen. Im Falle von high throughput Experimenten liegt ein Lösungsvolumen in der Regel im Bereich von 0,01 µl bis 100 µl, insbesondere von 0,01 µl bis 5 µl.

Das sichtbare Licht weist Wellenlängen zwischen ca. 380 nm und 800 nm auf. UV Licht weist Wellenlängen von weniger als ca. 380 nm bis zu ca. 1 nm auf. IR Licht weist Wellenlängen von mehr als 800 nm bis zu 10.000 nm, im Falle des nahen IR von mehr als 800 nm bis zu ca. 2.000 nm, auf.

Kristallisationsbedingungen werden dadurch eingestellt, dass einer Lösung mit Makromolekülen Substanzen zugegeben werden und/oder die Lösung physikalischen oder physikochemischen Bedingungen (Temperatur, Druck, Konzentration, Salzkonzentration, etc.) ausgesetzt wird, welche zur Kristallisation der Makromoleküle führen oder prospektiv hierzu führen.

Der Begriff der Lösung umfasst im Rahmen der Erfindung auch Gele.

Geeignete Kristallgrößen für beispielsweise die Röntgenstrukturanalyse liegen typischerweise im Bereich von 0,001 bis 50 µl, insbesondere von 0,01 bis 5 µl. Die Sollpartikelgröße liegt in der Regel bei zumindest 10% des vorstehenden Minimalwertes, vorzugsweise innerhalb des angegebenen Bereiches.

Im Folgenden wird die Erfindung anhand von lediglich Ausführungsformen darstellenden Beispielen näher erläutert.

### 1: Beispielhafter erfindungsgemäßer apparativer Aufbau.

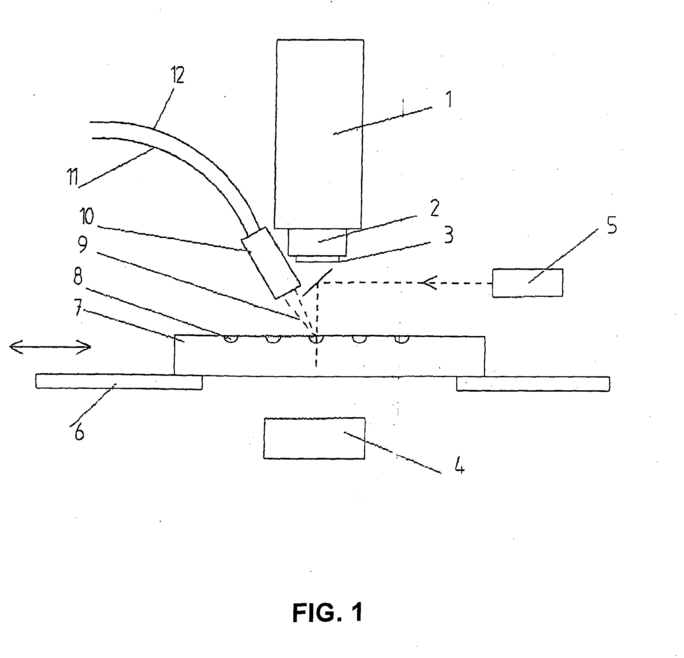

In der Figur 1 ist eine erfindungsgemäße Apparatur dargestellt. Man erkennt ein Trägerelement 7, welches eine Mehrzahl von Vertiefungen 8 aufweist. Das Trägerelement 7 ist für sichtbares Licht transparent. In jeder Vertiefung 8 ist jeweils ein Lösungsvolumen eingebracht, welches neben dem Lösungsmittel Biomoleküle einer Biomolekülspezies enthält. Im Beispiel ist die Biomolekülspezies Glucoseisomerase. Bezüglich der weiteren Komponenten wird auf das Beispiel 2 verwiesen.

Oberhalb des Trägerelementes 7 erkennt man die wesentlichen Elemente einer DLS Apparatur, nämlich einen Messkopf 10, in welchem die Enden von zwei Lichtleitern 11, 12 angeordnet und fixiert sind. An das entgegengesetzte Ende des Lichtleiters 12 ist ein Laser optisch angeschlossen. Das vom Laser emittierte monochromatische Licht wird mittels des Lichtleiters 12 auf das in der Figur 1 mittig angeordnete Lösungsvolumen (Messposition) gerichtet. An das entgegengesetzte Ende des Lichtleiters 11 ist ein schneller und empfindlicher Detektor, beispielsweise ein Photomultiplier, optisch angeschlossen. Aus dem Lösungsvolumen rückgestreute Photonen treten in den Lichtleiter 11 ein, gelangen hierdurch zum Detektor und werden so gemessen. Eine an den Detektor angeschlossene Auswerteeinheit, welcher der Einfachheit halber nicht dargestellt ist, erfasst die zeitlichen Fluktuationen der Rückstreuintensität bei der Wellenlänge des Lasers, woraus letzlich mit einer Partikelgröße bzw. Partikelgrößenverteilung korrelierte Signale bzw. Daten gewonnen werden. Bei der Anordnung der Enden der Lichtleiter 11, 12 ist die Konfiguration so getroffen, dass die Raumwinkel der Lichtemission und der Detektion rückgestreuter Photonen in dem Lösungsvolumen fokussiert sind. Aufgrund der geringen Partikeldichte bzw. Dichte an Biomolekülkristallen sowie der geringen Anforderungen an die Messgenauigkeit ist es entbehrlich, in verschiedenen Rückstreuwinkeln zu detektieren oder mit verschiedenen Primärlichtwellenlängen zu arbeiten.

Oberhalb des Trägerelementes 7 erkennt man des Weiteren eine Kamera 1 mit einem Objektiv 2 sowie ein UV Filter 3. Das UV Filter ist UV-undurchlässig, jedoch durchlässig für die längeren Wellenlängen des Fluoreszenzlichtes. Zur Fluoreszenzanregung ist eine bei ca. 360 nm emittierende UV-Lichtquelle 5 vorgesehen, deren Licht über einen halbdurchlässigen Spiegel in jenes Lösungsvolumen geleitet wird, in welches das vom Laser emittierte monochromatische Licht fokussiert ist. Mittels der Kamera 1 wird ein zweidimensionales Bild des Lösungsvolumens oder eines Teilbereiches hieraus aufgenommen. Die Kamera ist an eine Auswerteelektronik angeschlossen, welche maximale Intensitäten von Lichtpunkten oder Lichtpunktclustern auf dem Sensor der Kamera detektiert.

Schließlich erkennt man eine Lichtquelle 4 für sichtbares Licht, welche unterhalb des transparenten Trägerelementes 7 angeordnet ist, und welche das Licht in Richtung der Kamera durch das Trägerelement 7 emittiert. Da der Spiegel halbdurchlässig ist, läßt sich so mittels der Kamera 1 ein normales Durchlichtbild des Lösungsvolumens gewinnen und betrachten.

Das Trägerelement 7 ist auf einem Basiselement 6 angeordnet, welches als beweglicher Tisch ausgebildet ist. Das Basiselement 6 ist mittels einer Steuerungsvorrichtung und an das Basiselement mechanisch angeschlossener Antriebselemente in Richtungen parallel zu den Hauptflächen des Trägerelementes 7 bzw. des Basiselementes 6 hin- und herbewegbar. Dabei bewirkt die Steuerungsvorrichtung, dass verschiedene Lösungsvolumina nacheinander und nach Maßgabe von Fortschaltsignalen in die Messposition bewegt werden, welche dadurch charakterisiert ist, dass das zu messende Lösungsvolumen im Fokus der DLS Apparatur zum Ruhen kommt.

### 2: Kristallisation eines Biomoleküles.

In den Lösungsvolumen des Trägerelementes 7 werden die folgenden Kristallisationsversuche durchgeführt, und zwar im Wege der Bestimmung der optimalen Fällungskonzentration an Ammoniumsulfat zur Fällung von Glucoseisomerase.

Als Trägerelement 7 wird eine Linbroplatte verwendet. In je zwei Kammern der Linbroplatte werden 500 µl gleiche Ammoniumsulfatlösungen (Puffer) aus einer Konzentrationsreihe, beginnend bei 1,5 M, endend bei 2,6 M, aufsteigend im 0,1 M Schritten, eingebracht. Man erhält einen Satz Lösungsvolumenpaare der jeweiligen Konzentrationsstufen. Die Ränder der Lösungsvolumina werden jeweils mit einem Wulst aus einer Silikonmasse zu Abdichtungszwecken versehen.

Parallel hierzu wird ein Satz von silikonierten Deckgläschen mit 3 µl Proteinlösung (30 mg/ml Puffer) und 3 µl Ammoniumsulfatlösung durch mittige Applikation versehen. Es erfolgt eine vorsichtige Vermischung. Dabei korrespondiert jeweils ein Deckgläschenpaar mit den Lösungsvoluminapaaren aufgrund der jeweils gleichen Ammoniumsulfatkonzentrationen. Die Deckgläschen werden umgedreht und auf die Lösungsvolumina in der Linbroplatte bzw. auf die Wulste aufgedrückt, wobei die vorstehende Zuordnung aufgrund der Ammoniumsulfatkonzentration beachtet wird.

Nach Aufsetzen aller Deckgläschen wird der Deckel der Linbroplatte mit etwas Knetmasse leicht erhöht und auf die Linbroplatte aufgesetzt. Spätesten hiernach erfolgt eine Zuordnung und Registrierung der jeweiligen Ammoniumsulfatkonzentrationen zu den Positionen der Lösungsvolumina. Sodann wird das Kristallisationsexperiment bei 4°C für 12 h in einem Kühlschrank durchgeführt.

### 3: High throughput Kristallisationsexperimente mit dem erfindungsgemäßen Verfahren.

Nach Beendigung des Kritallisationsexperimentes aus Beispiel 2 wird das Trägerelement 7 aus Beispiel 2 aus dem Kühlschrank entnommen und in die Apparatur gemäß Beispiel 1 eingesetzt. Die Steuerungsvorrichtung des Basiselementes 6 wird initialisiert, wodurch ein erstes Lösungsvolumen in die Messposition gefahren wird.

Sodann wird die DLS Apparatur durch ein Freischaltsignal der Steuerungsvorrichtung aktiviert und die Messung rückgestreuten Lichtes bzw. dessen Intensitätsfluktuation beginnt. Die nach Abschluss der Messung erhaltene und mit einer Partikelgröße bzw. einer Partikelgrößenverteilung korreliert Messgröße wird in der Auswerteinheit mit dem korrespondierenden Mindestmessgröße verglichen und wenn dieser Vergleich das Vorliegen von Partikeln einer definierten Mindestgröße ergibt, wird ein erstes Positivsignal generiert. Ansonsten wird ein Negativsignal generiert.

Hierauf werden durch die Auswerteinheit die UV Lichtquelle 5 und die Kamera 1 aktiviert und es wird ein Fluoreszenzbild registriert. Die Auswerteinheit vergleicht dann die gemessenen Intensitäten der Bildpunkte bzw. Bildpunktcluster des Fluoreszenzbildes mit einem Mindestintensitätswert, welcher oberhalb der Intensität der Fluoreszenz des Lösungsvolumens mit Protein, jedoch ohne Kristallisation (Hintergrund) liegt. Nach Maßgabe dieses Vergleiches in der Auswerteinheit wird ein zweites Positivsignal oder Negativsignal generiert.

Das erste und das zweite Positiv- bzw. Negativsignal werden dann in der Auswerteeinheit dem Lösungsvolumen in der Messposition zugeordnet und gespeichert. Wird für ein bestimmtes Lösungsvolumen sowohl ein erstes als auch ein zweites Positivsignal registriert, so ist dies indiziell, dass in dem betreffenden Lösungsvolumen eine Proteinkristallisation (und keine Salzkristallisation) stattgefunden hat.

Nachdem für das erste Lösungsvolumen das erste und zweite Signale erhalten wurden, erzeugt die Auswerteinheit das Fortschaltsignal, welches bewirkt, dass durch Bewegung des Basiselementes 6 das nächste Lösungsvolumen in die Messposition transportiert wird. Hierauf wird wiederum ein Freischaltsignal generiert, welches den vorstehend für das erste Lösungsvolumen beschriebenen Vorgang nunmehr für das zweite Lösungsvolumen ablaufen läßt. Dies wiederholt sich für jedes Lösungsvolumen, bis für jedes Lösungsvolumen erste und zweite Positiv- bzw. Negativsignale erhalten und zugeordnet worden sind.

Während der Messungen oder nach Abschluss aller Messungen kann die Auswerteeinheit auf einem Display eine Darstellung des Trägerelementes mit den Lösungsvolumina erzeugen, wobei die Lösungsvolumen nach Maßgabe zugeordneter erster und zweiter Positiv- bzw. Negativsignale unterschiedlich farblich dargestellt werden können. Lösungsvolumina mit zugeordnetem ersten und zweiten Positivsignal können beispielsweise rot zur Anzeige eines erfolgreichen Kristallisationsversuches erscheinen. Lösungsvolumina mit ersten Positivsignal und zweitem Negativsignal können beispielsweise blau zur Anzeige einer Salzkristallisation ohne Proteinkristallisation angezeigt werden. Lösungsvolumina mit erstem und zweiten Negativsignal können beispielsweise weiss zur Anzeige der Abwesenheit jeglicher Kristallisation angezeigt werden.

Anstelle einer Anzeige oder zusätzlich hierzu können die ersten und zweiten Positiv- bzw. Negativsignale zur Steuerung weiterer automatischer Prozesse, beispielsweise der Vorbereitung von nach Maßgabe erster und zweiter Positivsignale selektierter Lösungsvolumina für die Röntgenstrukturanalyse eingesetzt werden.

Insgesamt kann automatisch mit vergleichsweise sehr hoher Geschwindigkeit und Zuverlässigkeit eine Vielzahl von Kristallisationsexperimenten und anschließender Strukturanalyse durchgeführt werden.

## Patentansprüche

1. Verfahren zur Überwachung der Herstellung von Makromolekülkristallen, welche zumindest einen Fluoreszenzemitter enthalten, mit den folgenden Verfahrensstufen:
a) ein Lösungsvolumen enthaltend gelöste Makromoleküle einer Molekülspezies mit zumindest einem Fluoreszenzemitter wird Bedingungen unterworfen, welche die Makromoleküle zu Makromolekülkristallen kristallisieren lassen oder von welchen erwartet wird, dass sie die Makromoleküle zu Makromolekülkristallen kristallisieren lassen,
b) das Lösungsvolumen aus Stufe a wird mit kohärentem Licht bestrahlt und das von Makromolekülkristallen gestreute Licht wird in zumindest einem definierten Raumwinkelbereich mit Mitteln zur Detektion von Streulicht detektiert,
c) vor, gleichzeitig mit, oder nach Stufe b wird das Lösungsvolumen mit einer Lichtquelle (5) bestrahlt, deren Lichtemission zur Anregung des Fluoreszenzemitters geeignet ist und Fluoreszenzlicht wird mit Mitteln (1) zur Detektion von Fluoreszenzlicht detektiert.

2. Verfahren nach Anspruch 1, wobei die Makromolekülspezies eine Biomolekülspezies ist.

3. Verfahren nach Anspruch 1 oder 2, wobei die folgenden Verfahrensschritte angeschlossen werden:
d) die von den Mitteln zur Detektion von Streulicht erzeugten Signale werden einer Auswerteeinheit zugeführt, in welcher die Signale in eine Partikelgröße oder eine hiermit korrelierte Messgröße transformiert werden, wobei die Partikelgröße bzw. die Messgröße mit einer definierten Sollpartikelgröße bzw. Sollmessgröße verglichen wird,
e) die von den Mitteln zur Detektion von Fluoreszenzlicht erzeugten Signale werden einer Auswerteeinheit zugeführt, in welcher die Signale in eine Fluoreszenzintensität transformiert werden, wobei die Fluoreszenzintensität mit einer Sollfluoreszenzintensität verglichen wird,
f) Makromolekülkristalle werden selektiert, wenn die Partikelgröße oberhalb der Sollpartikelgröße und zugleich die Fluoreszenzintensität oberhalb der Sollfluoreszenzintensität liegt.

4. Verfahren nach einem der Ansprüche 1 bis 3, wobei eine Mehrzahl von Lösungsvolumina enthaltend gleiche oder verschiedene Makromolekülspezies gleichzeitig oder subsequent den Stufen a bis c oder a bis f unterworfen werden, wobei die Kristallisationsbedingungen der Stufe a in den verschiedenen Lösungsvolumina gleich oder verschieden sein können.

5. Verfahren nach Anspruch 4, wobei die Mehrzahl von Lösungsvolumina auf oder in einem Trägerelement (7) angeordnet sind.

6. Verfahren nach Anspruch 4 oder 5, wobei die Anzahl an Lösungsvolumina im Bereich von 5 bis 1000, vorzugsweise 50 bis 500, liegt.

7. Verfahren nach einem der Ansprüche 1 bis 6, wobei die Stufen b und c nacheinander, b nach c oder c nach b, durchgeführt werden.

8. Verfahren nach einem der Ansprüche 1 bis 7, wobei die in Stufe c verwendete Lichtquelle (5) eine UV Lichtquelle ist.

9. Verfahren nach einem der Ansprüche 1 bis 8, wobei die Mittel zur Detektion von Streulicht und/oder die Mittel (1) zur Detektion von Fluoreszenzlicht einen mit einem Ende hieran angeschlossenen Lichtleiter (11) aufweisen, dessen entgegengesetztes Ende auf das Lösungsvolumen gerichtet ist.

10. Verfahren nach einem der Ansprüche 1 bis 9, wobei die Mittel zur Detektion des Streulichtes und/oder des Fluoreszenzlichtes einen Photomultiplier aufweisen.

11. Verfahren nach einem der Ansprüche 1 bis 10, wobei zwischen dem Lösungsvolumen und den Mitteln (1) zur Detektion von Floureszenzlicht ein UV-Filter (3) zwischengeschaltet ist.

12. Vorrichtung zur Überwachung, vorzugsweise der Hochdurchsatzüberwachung, der Herstellung von Makromolekülkristallen,
mit einem auf einem Basiselement (6) angeordneten Trägerelement (7) auf oder in welchem ein Lösungsvolumen enthaltend gelöste Makromoleküle einer Makromolekülspezies anbringbar ist,
mit zumindest einer auf das Lösungsvolumen richtbaren Lichtquelle für kohärentes Licht,
mit einer auf das Lösungsvolumen richtbaren Lichtquelle (5) für Licht, welches zur Anregung eines Fluoreszenzemitters geeignet ist,
mit Mitteln zur Detektion von Streulicht aus dem Lösungsvolumen,
mit Mitteln (1) zur Detektion von Fluoreszenzlicht aus dem Lösungsvolumen, und
mit einer an die Mittel zur Detektion von Streulicht und die Mittel (1) zur Detektion von Fluoreszenzlicht angeschlossenen Auswerteeinrichtung.

13. Vorrichtung nach Anspruch 12, wobei das Trägerelement (7) eine Mehrzahl von Probenbereichen (8) zur Aufnahme jeweils eines Lösungsvolumens aufweist.

14. Vorrichtung nach Anspruch 12 oder 13, wobei die Mittel zur Detektion von Streulicht und/oder die Mittel (1) zur Detektion von Fluoreszenzlicht entweder einen gemeinsamen oder jeweils einen zugeordneten Lichtleiter (11) umfassen, dessen freies Ende auf das Lösungsvolumen gerichtet ist.

15. Vorrichtung nach einem der Ansprüche 12 bis 14, wobei das freie Ende des Lichtleiters (11) zur Aufnahme von Licht ausgerichtet ist, welches in einem Winkel von 0° bis 70° zur Achse des eingestrahlten Lichtes aus dem Lösungsvolumen emittiert wird.

16. Vorrichtung nach einem der Ansprüche 12 bis 15, wobei entweder das Trägerelement (7) oder die Mittel zur Detektion von Streulicht und die Mittel (1) zur Detektion von Fluoreszenzlicht gegenüber dem Basiselement (6) mittels einer Manipulatorvorrichtung verschiebbar sind.
